# EUROPEAN PATENT APPLICATION

(11) **EP 2 317 544 A1**
(43) Date of publication of application: **04.05.2011**
(21) Application number: 09804747.5
(22) Date of filing: 06.08.2009
(51) Int. Cl.: H01L 21/3205, H01L 23/12, H01L 23/52

(54) **SEMICONDUCTOR DEVICE**

(30) Priority: 06.08.2008 JP 2008203395
(71) Applicant: Fujikura, Ltd., Tokyo 135-8512 (JP)
(72) Inventor: WADA, Hideyuki, Sakura-shi Chiba 285-8550 (JP)
(74) Representative: Cabinet Plasseraud
(86) International application number: PCT/JP2009/003776
(87) International publication number: WO 2010/016260

(57) **Abstract**

A semiconductor device according to the present invention including: a semiconductor substrate having a through hole formed towards one surface side from the other surface side; an electrode pad arranged on the one surface side of the semiconductor substrate and partially exposed to the through hole; and a through electrode arranged at an inner side of the through hole and electrically connected to the electrode pad, wherein a connection portion between the electrode pad and the through electrode is arranged in a region within a plane of the electrode pad which is close to the center of the semiconductor substrate rather than to a center of the electrode pad.

## Description

### TECHNICAL FIELD

The present invention relates to a semiconductor device equipped with a through electrode.
Priority is claimed on Japanese Patent Application No. 2008-203395, filed August 6, 2008, the content of which is incorporated herein by reference.

### BACKGROUND ART

In recent years, the performance of electronic equipment such as mobile phones has been highly advanced, and with respect to the electronic devices such as integrated circuits (IC) and large-scale integrated circuits (LSI) and the optical devices such as optoelectronic integrated circuits (OEIC) and an optical pickup which are used in these equipment, developments in order to achieve the size reduction and high performance of the devices per se have been made in various places. For example, a technique for laminating and providing such devices in electronic equipment has been proposed. More specifically, a semiconductor device having a through electrode which penetrates a substrate, provided with a some kind of functional unit on one surface thereof, from the other surface to the one surface and is connected to an electrode pad formed on the one surface (for example, refer to Patent Document 1).

As the above-mentioned conventional semiconductor device, for example, there is a semiconductor device provided with a semiconductor substrate in which a through hole is formed; an interlayer insulating film formed on top of the surface of the semiconductor substrate; an electrode pad formed on the front surface of the semiconductor substrate via the interlayer insulating film; insulating layers formed on the inner side surface of the through hole and the back surface of the semiconductor substrate; a bump electrode interconnection formed on the back surface of the semiconductor substrate; a through electrode formed in the through hole; a land portion formed integrally with the through electrode in the periphery thereof and electrically connected to the bump electrode interconnection in the back surface of the semiconductor substrate; a connection portion between the electrode pad and the through electrode; a sealing resin (overcoat resin); and a solder bump provided in the bump electrode inside the opening of the sealing resin.

In the above-mentioned conventional semiconductor device, the through hole is provided by penetrating the semiconductor substrate and the interlayer insulating film from the back surface side of the semiconductor substrate, so that a portion of the back surface of the electrode pad is exposed in the back surface side of the semiconductor substrate. In addition, the through electrode is formed at the inner side of the through hole via the insulating layer and is electrically connected to a portion of the back surface of the electrode pad to form the connection portion with the electrode pad. Further, the connection portion is formed at the center of the electrode pad (for example, refer to Patent Document 1). In other words, the through hole and the through electrode are formed at the center of the electrode pad.

In the back surface side of the semiconductor substrate in the above-mentioned conventional semiconductor device, the land portion is integrally formed in the periphery of the through electrode and connects the through electrode and the bump electrode interconnection. The diameter of this land portion is made larger than the width of the bump electrode interconnection so as to secure the durability and reliability of connection with the bump electrode interconnection. The sealing resin is formed in the back surface side of the semiconductor substrate, covers the bump electrode interconnection and the land portion in the periphery of the through electrode, and secures the insulation properties of the back surface of the semiconductor substrate. However, this sealing resin is not provided immediately close to the edge (chip edge) of the semiconductor substrate for the sake of suppressing the chipping during the scribing step or dicing step or the like.

### PRIOR ART DOCUMENTS

### PATENT DOCUMENTS

[Patent Document 1] Japanese Unexamined Patent Application, First Publication No. H 5-343385

### DISCLOSURE OF INVENTION

### PROBLEMS TO BE SOLVED BY THE INVENTION

However, in the conventional semiconductor device described above, if the electrode pad is arranged in the vicinity of the chip edge (scribe edge), as a result, the through electrode and the land portion will also be arranged in the vicinity of the chip edge. Further, in the back surface side of the semiconductor substrate, the edge (formed edge) of the sealing resin that covers these through electrode and land portion will also become closer to the chip edge depending on the position of the land portion. For this reason, in those cases where the electrode pad is arranged in the vicinity of the chip edge (scribe edge), the sealing resin (overcoat resin) as well as the land portion come into contact and interfere with the chip edge, thereby causing defects such as the chipping of these sealing resin and land portion at times.

Since the through hole is formed from the back surface side of the semiconductor substrate towards the front surface side of the semiconductor substrate, in general, the opening in the back surface side of the semiconductor substrate of this through hole is wider than the opening in the front surface side of the semiconductor substrate (i.e., the bottom side of the through hole). For this reason, the diameter of the land portion formed in the periphery of the opening of the through hole in the back surface side of the semiconductor substrate tends to become larger. Especially when the electrode pad is arranged in the vicinity of the chip edge, the contact and interference between the sealing resin, the land portion and the chip edge (scribe edge) become prominent. If the opening diameter in the back surface side of the semiconductor substrate of the through hole is made small in order to avoid the above-mentioned problem, the area of the connection portion between the electrode pad and the through electrode becomes small. When viewing the through hole from the back surface side of the semiconductor substrate, in those cases where the planar shape thereof is either a circle or a square, if the length of the radius or side of the through hole is reduced, the area of the connection portion between the through electrode and the electrode pad is reduced by the square of the reduced length. For this reason, the value of resistance at this connection portion increases rapidly, thereby deteriorating the reliability of the connection portion.

As described above, in the conventional semiconductor device, if the electrode pad is arranged in the vicinity of the chip edge (scribe edge), it has been difficult at times to secure the connection reliability between the through electrode and the electrode pad in the front surface side of the semiconductor substrate while preventing the overcoat resin (sealing resin) and/or the land portion from contacting and interfering with the chip edge (scribe edge) in the back surface side of the semiconductor substrate.

The present invention is made in view of such conventional circumstances and its object is to provide a semiconductor device capable of preventing the overcoat resin and/or the land portion which is formed at the position of the through electrode from contacting and interfering with the edge of the semiconductor substrate while securing the connection reliability between the through electrode and the electrode pad.

### MEANS FOR SOLVING THE PROBLEMS

The present invention employs the following aspects in order to solve the above-mentioned problems and to achieve the object.
(1) A semiconductor device of the present invention includes: a semiconductor substrate having a through hole formed towards one surface side from the other surface side; an electrode pad arranged on the one surface side of the semiconductor substrate and partially exposed to the through hole; and a through electrode arranged at an inner side of the through hole and electrically connected to the electrode pad, wherein the connection portion between the electrode pad and the through electrode is arranged in a region within the electrode pad plane close to the center of the semiconductor substrate rather than to the center of the electrode pad.
(2) The semiconductor device according to the above aspect (1), in which the opening area of the through hole formed on the other surface side of the semiconductor substrate may be larger than the opening area of the through hole formed on the one surface side of the semiconductor substrate.
(3) The semiconductor device according to the above aspect (1) or (2), in which a planar shape of the through hole may be substantially an ellipse or substantially a rectangle when seen from the one surface side or the other surface side of the semiconductor substrate.

### EFFECTS OF THE INVENTION

In the semiconductor device described in the above aspect (1), the connection portion between the electrode pad and the through electrode is arranged in a region within the electrode pad plane close to the center of the semiconductor substrate rather than to the center of the electrode pad. For this reason, even if the electrode pad is arranged in the vicinity of the edge of the semiconductor substrate, the through electrode can be arranged at a position distant from the edge of the semiconductor substrate while securing the connection reliability by sufficiently securing the area of the connection portion. As a result, it is possible to avoid the contact and interference between the overcoat resin or land portion which is formed at the position on the semiconductor substrate where the through electrode is arranged and the edge of the semiconductor substrate.

### BRIEF DESCRIPTION OF THE DRAWINGS

FIG. 1 is a partial plan view of a semiconductor device according to the present invention seen from the side of the back surface (the other surface) of a semiconductor substrate.
FIG. 2 is a partial cross sectional view of the semiconductor device according to the present invention.
FIG. 3 is a partial plan view for explaining the position and shape of a connection portion within the electrode pad plane provided in the semiconductor device according to the present invention (when the planar shape of the connection portion is substantially a circle).
FIG. 4 is a partial plan view for explaining the position and shape of a connection portion within the electrode pad plane provided in the semiconductor device according to the present invention (when the planar shape of the connection portion is substantially an ellipse).

### EMBODIMENTS FOR CARRYING OUT THE INVENTION

The present invention will be described in detail below by referring to the drawings. However, the present invention is not limited only to these, and various modifications can be made as long as they do not depart from the scope of the present invention.

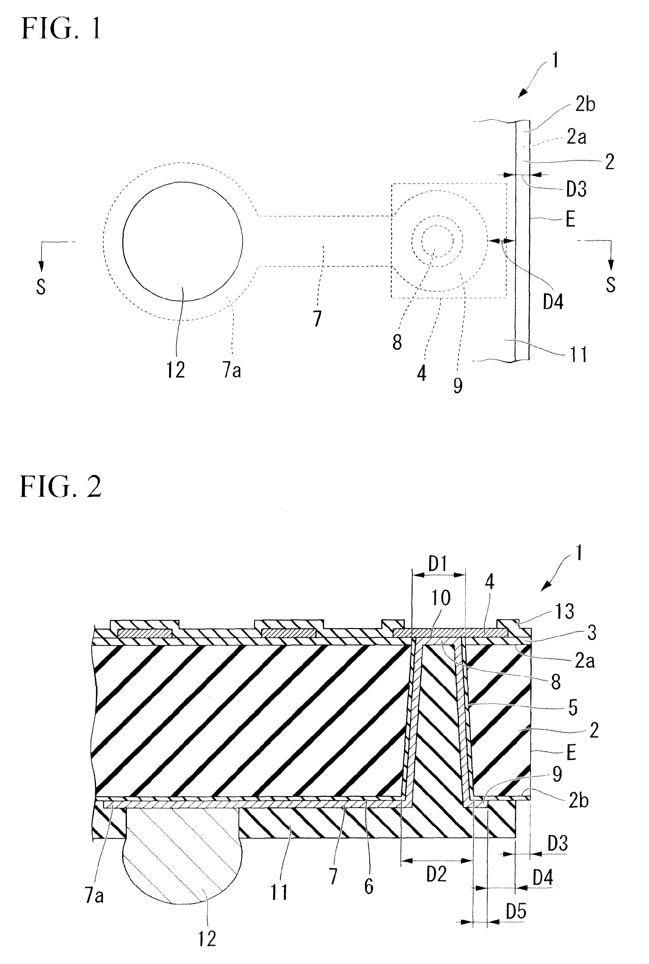

FIG. 1 is a partial plan view of a semiconductor device 1 according to an embodiment of the present invention seen from the back surface 2b side of a semiconductor substrate 2. In addition, FIG. 2 is a cross sectional view, taken along the S-S line of FIG. 1. The semiconductor device 1 shown in FIGS. 1 and 2 includes: the semiconductor substrate 2 in which a through hole 5 is formed; an interlayer insulating film 3; an electrode pad 4; an insulating layer 6; a bump electrode interconnection 7; a through electrode 8; a land portion 9; a sealing resin (overcoat resin) 11; a solder bump 12; and a protective film (passivation film) 13. In this semiconductor device 1, the electrode pad 4 and the through electrode 8 are electrically connected to form a connection portion 10.

The through electrode 8, the land portion 9 and the bump electrode interconnection 7 are integrally formed, for example, by patterning the same conductive layer.
The sealing resin 11 is formed, for example, so as to cover the back surface 2b of the semiconductor substrate 2 where the insulating layer 6, the bump electrode interconnection 7 and the land portion 9 are formed, after filling the inside of the through hole 5, in which the insulating layer 6 and the through electrode 8 are formed, with an insulator through the chemical vapor deposition (CVD) method or the like.

### [Semiconductor substrate 2]

The semiconductor substrate 2 is either one chip partitioned by a scribe line in a semiconductor wafer such as a silicon wafer or a semiconductor chip prepared by cutting (dicing) the above-mentioned semiconductor wafer into a chip size. An edge E of the semiconductor substrate 2 shown in FIGS. 1 and 2 indicate a position, before the dicing process, which is to become a chip edge (scribe edge) as the result of dicing, and is the actual chip edge (the edge of the semiconductor device 1) after the dicing process. The thickness of the semiconductor substrate 2 is, for example, about several hundreds of micrometers.

In a front surface 2a of a semiconductor substrate 2, an 1C chip, a charge coupled device (CCD), a micro relay, a micro switch, a pressure sensor, an acceleration sensor, a high-frequency filter, a micromirror, a microreactor, a µ-TDS, a DNA chip, a micro electro mechanical system (MEMS) device, or a some kind of functional unit with respect to a micro fuel cell or the like has been incorporated (not shown).

### [Electrode pad 4]

The electrode pad 4 is provided in the front surface 2a of the semiconductor substrate 2 via the interlayer insulating film 3. This electrode pad 4 is electrically connected to the functional unit provided in the front surface 2a of the semiconductor substrate 2. A portion of the back surface side of this electrode pad 4 is exposed in the back surface 2b side of the semiconductor substrate 2 by the through hole 5. In addition, the electrode pad 4 has the connection portion 10 with the through electrode 8, which is formed inside the through hole 5, within the exposed portion. In the front surface side of the electrode pad 4, the protective film 13 having an opening is formed. Because of this opening, a portion of the front surface of the electrode pad 4 is exposed from the protective film 13.

As the material for the electrode pad 4, a material having excellent conductivity such as aluminum (Al), copper (Cu), an aluminum-silicon (Al-Si) alloy, an aluminum-silicon-copper (Al-Si-Cu) alloy or the like can be used.

### [Through hole 5]

The through hole 5 is formed towards the side of one surface (front surface) 2a from the side of the other surface (back surface) 2b of the semiconductor substrate 2. The through hole 5 is penetrating through the semiconductor substrate 2 and the interlayer insulating film 3 arranged in the front surface 2a thereof so as to expose a portion of the back surface of the electrode pad 4 in the back surface 2b side of the semiconductor substrate 2. When viewing the through hole 5 from the back surface 2b side or the front surface 2a side of the semiconductor substrate 2, in general, the planar shape of the through hole 5 is a substantial circle, a substantial square or the like. However, in the present invention, as described later, the planar shape of the through hole 5 may also be a substantial ellipse, a substantial rectangle or the like. In FIGS. 1 and 2, as an example, a semiconductor device in which the planar shape of the through hole 5 is a substantial circle is shown.

### [Insulating layer 6]

The insulating layer 6 is formed in the back surface 2b of the semiconductor substrate 2 and the inner side surface of the through hole 5. As the insulating layer 6, for example, silicon oxide (SiO₂) exhibiting excellent insulating properties and also excellent coverage when depositing the insulating layer 6 inside the through hole 5 can be used.

### [Conductive layer (bump electrode interconnection 7, through electrode 8 and land portion 9)]

The through electrode 8 is formed on the inner side of the through hole 5 via the insulating layer 6. The through electrode 8 is electrically connected to a portion of the back surface of the electrode pad 4 exposed at the bottom of the through hole 5 to form the connection portion 10.
The land portion 9 is integrally formed with the through electrode 8 on top of an insulating layer in the periphery of the through electrode 8 in the back surface 2b side of the semiconductor substrate 2.
The bump electrode interconnection 7 has a bump electrode 7a, in which the solder bump 12 is to be provided. The bump electrode interconnection 7 is connecting this bump electrode 7a with the through electrode 8 and the land portion 9 formed in the periphery thereof.

In those cases where the bump electrode interconnection 7, the through electrode 8 and the land portion 9 are integrally formed using the same conductive layer, as the material for this conductive layer, for example, copper (Cu) exhibiting excellent conductivity and coverage can be used. It is also possible to form the bump electrode interconnection 7 separately after forming the through electrode 8 and the land portion 9. The through electrode 8 or the above-mentioned conductive layer including this electrode can be formed, for example, by a plating method or the like.

### [Sealing resin 11]

The sealing resin 11 is formed, on top of the insulating layer 6 in the back surface 2b of the semiconductor substrate 2, on top of the bump electrode interconnection 7, on top of the land portion 9, and inside the through hole 5 where the through electrode 8 is formed. However, this sealing resin is not formed immediately close to the chip edge (scribe edge) E of the semiconductor device 1 (semiconductor substrate 2) for the sake of suppressing the chipping or the like. As the sealing resin 11, phospho-silicate glass (PSG), boron-doped phospho-silicate glass (BPSG) or the like can be used. The sealing resin 11 can be prepared, for example, by filling inside the through hole 5 with silicon oxide (SiO₂), silicon nitride (Si₃N₄) or the like through the CVD method or the like, follower by the formation of the aforementioned resin in the back surface 2b of the semiconductor substrate 2.

### [Solder bump 12]

The solder bump 12 is provided on top of the bump electrode 7a of the bump electrode interconnection 7. The solder bump 12 electrically connects the semiconductor device 1 with other semiconductor devices or other substrates that are laminated in the back surface side of the semiconductor device 1.

In the semiconductor device 1 of the present embodiment, the connection portion 10 between the electrode pad 4 and the through electrode 8 is formed in a region within the plane of the electrode pad 4 which is close to the center of the semiconductor substrate 2 (the region shifted to the left hand side in FIGS. 1 and 2) rather than to the center of the electrode pad 4. Accordingly, the bottom diameter (the opening diameter in the front surface 2a side of the semiconductor substrate 2) D 1 of the through hole 5 has the same size as in the conventional through holes. In other words, the opening width of the through hole 5 in the front surface 2a side of the semiconductor substrate 2 (i.e., the opening area) is the same as in the conventional through holes. As a result, the same level of connection reliability of the connection portion 10 between the electrode pad 4 and the through electrode 8 as those in the conventional cases can be secured.

Further, in the semiconductor device 1 according to the present invention, by shifting the position of the through electrode 8 close to the center of the semiconductor substrate 2, the distance from the chip edge (scribe edge) E of the semiconductor substrate 2 to the through electrode 8 (i.e., D3 + D4 + D5) can be made longer than the conventional semiconductor devices where the connection portion is formed in the center of the electrode pad.
In this case, the distance from the chip edge (scribe edge) E to the land portion 9 (i.e., D3 + D4) becomes longer than that in the conventional cases. For example, even if the size of the annular width D5 of the land portion 9 and the size of the overlapping region D4 from the circumferential edge of the land portion 9 of the sealing resin 11 to the edge of the sealing resin 11 are made the same as in the conventional semiconductor device, the size of D3 from the edge of the sealing resin 11 to the chip edge can be made larger than that in the conventional device. As a result, the contact and interference between the sealing resin 11 or the land portion 9 and the chip edge E can be avoided, thereby preventing the chipping which occurs in these sealing resin 11 and the land portion 9 during the scribing step or the dicing step. In addition, if the chip edge E is set close to the center of the semiconductor substrate 2 within a range where the size of D3 of at least the same level as in the conventional cases can be secured, it is also possible to reduce the size of the semiconductor device 1.

### [Tapered through hole 5]

The through hole 5 is formed by the processing due to the dry etching process or the like from the back surface 2b side of the semiconductor substrate 2 towards the front surface 2a side of the semiconductor substrate 2 (i.e., the side of the electrode pad 4). In general, in the through hole 5, the opening diameter (opening area) of the through hole 5 in the back surface 2b side of the semiconductor substrate 2 is larger than the opening diameter (opening area) in the front surface 2a side of the semiconductor substrate 2. In FIGS. 1 and 2, the cross sectional shape of the through hole 5 in the thickness direction of the semiconductor substrate 2 has a tapered shape, in which the opening diameter D2 of the through hole 5 in the back surface 2b side of the semiconductor substrate 2 is larger than the opening diameter (i.e., the bottom diameter of the through hole 5) D 1 in the front surface 2a side of the semiconductor substrate 2. For example, D2/D = 1.5.

In those cases where the through electrode 8 is provided inside the through hole 5 having such a tapered shape, if the opening diameter D 1 (which is equivalent to the diameter of the connection portion 10) of the through hole 5 which is formed in the front surface 2a side of the semiconductor substrate 2 is prepared based on the connectivity with the electrode pad 4, the opening diameter D2 of the through hole 5 formed in the back surface 2b side of the semiconductor substrate 2 increases and the diameter of the land portion 9 also increases. In other words, the edge of the land portion 9 and the edge (formed edge) of the sealing resin 11 become closer to the chip edge (scribe edge) E, and the size of D3 reduces. Otherwise, the size of the annular width D5 of the land portion 9 has to be made small. In such a case, if the device according to the present invention is applied, in which the through electrode 8 is formed at a position shifted to the center of the semiconductor substrate 2 rather than to the center of the electrode pad 4, the above-mentioned effects according to the present invention can be achieved remarkably, and the cracks or chipping of the sealing resin 11 and the land portion 9 during the dicing step or the scribing step which is caused by the contact and interference between the sealing resin 11 or the land portion 9 and the chip edge E can be prevented more effectively. In addition, since there is no need to reduce the size of the annular width D5 of the land portion 9, the durability or reliability of the connection with the bump electrode interconnection 7 can be secured sufficiently.

The insulating layer 6, the through electrode 8 and the sealing resin 11 serving as an insulator that are provided in the through hole 5 are formed from the back surface 2b side of the semiconductor substrate 2. For this reason, the tapered shape of the through hole 5, in which the opening in the back surface 2b side of the semiconductor substrate 2 is made wide as described above, is suited for forming the insulating layer 6, the through electrode 8, the sealing resin 11 or the like inside the through hole 5. As a result, voids or the like hardly occur during the formation of these components inside the through hole 5, and thus the durability and reliability of the connection portion 10 between the through electrode 8 and the electrode pad 4 can be improved.

The through hole 5 having such a tapered shape can be formed, following the formation of an opening having a circular or square shape or the like in a resist pattern in the back surface 2b of the semiconductor substrate 2, by a dry etching process or a wet etching process in the semiconductor substrate 2 at a position where the opening is formed. In addition, the through hole 5 having a tapered shape can also be formed at the predetermined position in the semiconductor substrate 2 by a machining process using a micro-drill, the laser processing, the photo assisted electro-chemical etching (PAECE) or the like.

The through hole 5 formed in the semiconductor device 1 according to the present invention includes not only those having a rectangular cross sectional shape in the thickness direction of the semiconductor substrate 2, but also those having the above-mentioned tapered shape. Here, with respect to the through hole 5, the term "tapered shape" includes all of the hole shapes in which the opening of the through hole 5 in the back surface 2b side of the semiconductor substrate 2 (in the side of the land portion 9) is wider than the opening in the front surface 2a side of the semiconductor substrate 2 (in the side of the electrode pad 4). The through hole 5 according to the present invention having a tapered shape (or the through electrode 8) includes not only those in which the cross section in the thickness direction of the semiconductor substrate 2 is linearly inclined as shown in FIG. 2, but also, for example, those in which the cross section in the thickness direction of the semiconductor substrate 2 is inclined in a curved manner, and even those in which the central axis is inclined with respect to the thickness direction of the semiconductor substrate 2. In addition, the tapered shape also include those in which a portion of the cross section of the through hole 5 in the thickness direction of the semiconductor substrate 2 becomes parallel to the thickness direction of the semiconductor substrate 2.

### [Plurality of electrode pads 4]

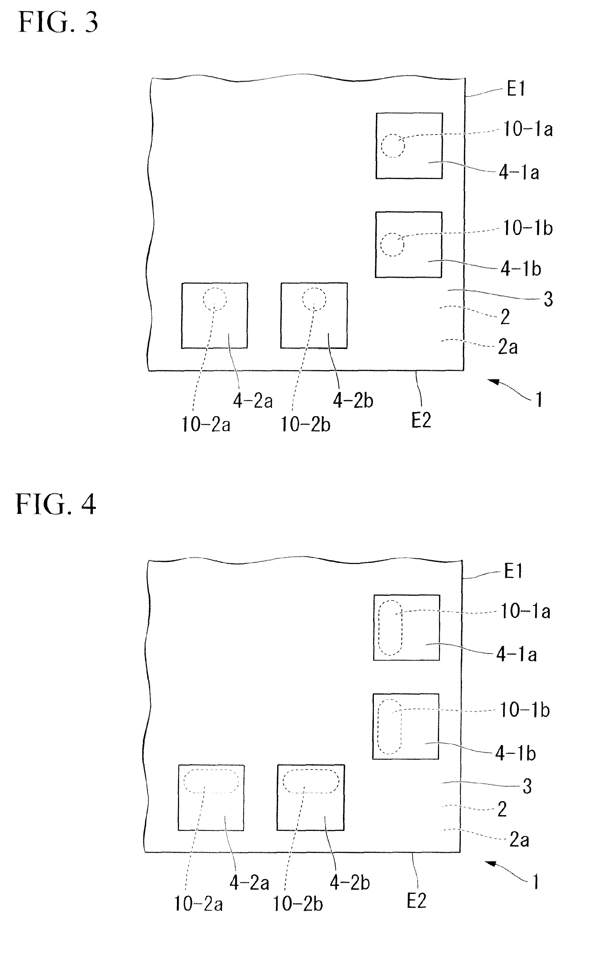

FIGS. 3 and 4 are showing an embodiment when a plurality of electrode pads 4 are provided in the vicinity of the chip edge of the semiconductor device. FIGS. 3 and 4 are partial plan views for explaining the position and shape of the connection portion 10 within the plane of the electrode pad 4 provided in the semiconductor device 1 of the present embodiment (partial plan views seen from the front surface of the semiconductor device 1). As shown in FIGS. 3 and 4, in the semiconductor device 1 of the present embodiment, a plurality of electrode pads 4 (i.e., 4-1a, 4-1b, 4-2a and 4-2b) are formed in the vicinity of the chip edges (scribe edges) E1 and E2. In this embodiment, the connection portions 10 (10-1a, 10-1b, 10-2a and 10-2b) are each formed in the planes of the respective electrode pads 4. In FIG. 3, a case in which the planar shape of the connection portion 10 is a substantial circle is shown. In FIG. 4, a case in which the planar shape of the connection portion 10 is substantially an ellipse is shown.

In FIGS. 3 and 4, the electrode pads 4-1a and 4-1b are each formed in the vicinity of the chip edge E1. The connection portions 10-1a and 10-1b each formed within the region of the electrode pads 4-1a and 4-1b are formed in regions close to the center of the semiconductor substrate 2 which are further away from the chip edge E1 rather than the centers of the electrode pads 4-1a and 4-1b. That is, the through electrodes 8 (through holes 5) are formed in regions within the planes of the electrode pads 4-1a and 4-1b which are close to the center of the semiconductor substrate 2 rather than to the centers of the electrode pads 4-1a and 4-1b so as to depart from the chip edge E1.

In the same manner, in FIGS. 3 and 4, the electrode pads 4-2a and 4-2b are each formed in the vicinity of the chip edge E2 (a chip edge which is perpendicular to E1). The connection portions 10-2a and 10-2b each formed within the region of the electrode pads 4-2a and 4-2b are formed in regions close to the center of the semiconductor substrate 2 which are further away from the chip edge E2 rather than the centers of the electrode pads 4-2a and 4-2b. That is, the through electrodes 8 (through holes 5) are formed in regions within the planes of the electrode pads 4-2a and 4-2b which are close to the center of the semiconductor substrate 2 rather than to the centers of the electrode pads 4-2a and 4-2b so as to depart from the chip edge E2.

As described above, even in those cases where a plurality of electrode pads 4 are each formed in the chip edges (scribe edges) E1 and E2, by arranging the connection portions 10 in regions within the planes of each of the electrode pads 4 which are close to the center of the semiconductor substrate 2 rather than to the centers of the electrode pads 4, the edges between the through electrodes 8, the land portions 9 and the overcoat resins 11 that seal them can be arranged at positions that are distant from the chip edges E1 and E2 while securing the reliability of each of the connection portions 10. As a result, in the back surface 2b of the semiconductor substrate 2, the contact and interference between the edges of the sealing resins (overcoat resins) 11 or the land portions 9 and the chip edges (scribe edges) E1 and E2 can be avoided, thereby preventing the chipping which occurs during the dicing step or the scribing step.

In other words, by shifting the positions of the respective connection portions 10 that correspond to each of the electrode pads 4 to the regions close to the center of the semiconductor substrate 2, the areas of each connection portions 10 can be secured to the same level as those in the conventional cases. Moreover, a wide area for forming the respective land portions 9 and the overcoat resins 11 between each of the through electrodes 8 and the chip edges (scribe edges) E1 and E2 can be secured. As a result, for example, even if the scribe edges E (E1 and E2) are set to more inner sides than in the conventional cases, the size of the semiconductor device 1 can be reduced without causing defects such as the chipping of the overcoat resin 11 and the land portion 9 and also without any limitations in terms of the position at which the electrode pad 4 is arranged.

### [Planar shape of through electrode 8]

In order to increase the area of the connection portion 10 to further enhance the connection reliability while shifting the arrangement position of the through electrode 8 further away from the chip edge (scribe edge) E, it is effective to modify the planar shape of the through hole 5 to a substantial ellipse, a substantial rectangle or the like rather than to a circle or a square. FIG. 4 shows an example where the planar shape of the through hole 5 is made into a substantial ellipse. By making the planar shape of the through hole 5 into a substantial ellipse, a substantial rectangle or the like, the planar shape of the through electrode 8 and the shape of the connection portion 10 also become a substantial ellipse, a substantial rectangle or the like.

When making the planar shape of the through electrode 8 into a substantial ellipse or a substantial rectangle as described above, the minor axis of the substantial ellipse or the short side of the substantial rectangle is arranged in the direction in which the contact and interference with the chip edge (scribe edge) E occurs (i.e., the direction in which securing of a wide space with the chip edge E is desirable). On the other hand, the major axis of the substantial ellipse or the long side of the substantial rectangle is arranged in the direction in which a plenty of space is available. As a result, while securing the area of the connection portion 10, much wider space for forming the land portion 9 and the sealing resin (overcoat resin) 11 can be secured between the chip edge E and the through electrode 8.

In the embodiment shown in FIG. 4, the electrode pads 4-1a and 4-1b are each formed in the vicinity of the chip edge E1. With respect to the connection portions 10-1a and 10-1b having substantially elliptical shapes and each formed within the region of the electrode pads 4-1a and 4-1b, the major axes thereof are arranged in a direction parallel to the chip edge E1. On the other hand, the minor axes of the connection portions 10-1a and 10-1b having substantially elliptical shapes are arranged in a direction perpendicular to the chip edge E1. The through electrodes 8 (through holes 5) are formed in the semiconductor substrate 2 so as to have such major-axis and minor-axis directions.

In the same manner, in the embodiment shown in FIG. 4, the electrode pads 4-2a and 4-2b are each formed in the vicinity of the chip edge E2 (a chip edge which is perpendicular to the chip edge E1). With respect to the connection portions 10-2a and 10-2b having substantially elliptical shapes and each formed within the region of the electrode pads 4-2a and 4-2b, the major axes thereof are arranged in a direction parallel to the chip edge E2. On the other hand, the minor axes of the connection portions 10-2a and 10-2b having substantially elliptical shapes are arranged in a direction perpendicular to the chip edge E2. The through electrodes 8 (through holes 5) are formed in the semiconductor substrate 2 so as to have such major-axis and minor-axis directions.

When making the planar shape of the connection portion 10 (through electrode 8) into a substantial ellipse or a substantial rectangle as described above, if the radius of the minor axis thereof is made the same as the radius of the case where the connection portion has a circular shape, the connection area can be increased by, for example, twofold or more, as compared to the case where the connection portion has a circular shape. Alternatively, for example, if the connection portion 10 (through electrode 8) having a substantially elliptical shape is configured so that the radius thereof in the major axis direction and the radius thereof in the minor axis direction are 1.5 times and 0.7 times, respectively, with respect to the radius of the connection portion 10 having a circular shape, in this connection portion 10 having a substantially elliptical shape, the same connection area as that of the connection portion 10 having a circular shape can be obtained.

As described above, by making the planar shape of the through electrode 8 (through hole 5 or connection portion 10) into a substantial ellipse, a substantial rectangle or the like, the through electrode 8 can be arranged further away from the chip edge (scribe edge) E, and the area of the connection portion 10 can also be increased to further enhance the connection reliability.

The through hole 5 having such a substantially elliptical shape, a substantially rectangle shape or the like can be formed by a dry etching process or a wet etching process, following the formation of an opening having a substantially elliptical shape, a substantially rectangle shape or the like in a resist pattern in the back surface of the semiconductor substrate 2. In addition, the through hole 5 having these shapes can also be formed by a machining process using a micro-drill, the laser processing, the PAECE or the like.

### INDUSTRIAL APPLICABILITY

The present invention can be applied widely to the semiconductor devices equipped with a through electrode.

### DESCRIPTION OF THE REFERENCE SYMBOLS

- 1:: Semiconductor device
- 2:: Semiconductor substrate
- 2a:: Substrate front surface
- 2b:: Substrate back surface
- 3:: Interlayer insulating film
- 4:: Electrode pad
- 5:: Through hole
- 6:: Insulating layer
- 7:: Bump electrode interconnection
- 7a:: Bump electrode
- 8:: Through electrode
- 9:: Land portion
- 10:: Connection portion
- 11:: Sealing resin (overcoat resin)
- 12:: Solder bump
- 13:: Protective film (passivation film)

## Claims

1. A semiconductor device comprising:
a semiconductor substrate having a through hole formed towards one surface side from the other surface side;
an electrode pad arranged on the one surface side of the semiconductor substrate and partially exposed to the through hole; and
a through electrode arranged at an inner side of the through hole and electrically connected to the electrode pad,
wherein a connection portion between the electrode pad and the through electrode is arranged in a region within a plane of the electrode pad which is close to the center of the semiconductor substrate rather than to a center of the electrode pad.

2. The semiconductor device according to Claim 1,
wherein an opening area of the through hole formed on the other surface side of the semiconductor substrate is larger than an opening area of the through hole formed on the one surface side of the semiconductor substrate.

3. The semiconductor device according to Claim 1 or 2,
wherein a planar shape of the through hole is substantially an ellipse or substantially a rectangle when seen from the one surface side or the other surface side of the semiconductor substrate.
